Europäisches Patentamt

European Patent Office

Office européen des brevets

(19)

(11) Publication number : **0 469 638 B1**

# (12) EUROPEAN PATENT SPECIFICATION

(45) Date of publication of patent specification :
**30.08.95 Bulletin 95/35**

(51) Int. Cl.$^6$ : **H01L 35/08**

(21) Application number : **91116598.3**

(22) Date of filing : **23.10.87**

(54) **A power detector comprising a thin film conductor.**

(30) Priority : **27.10.86 JP 253686/86**

(43) Date of publication of application :
**05.02.92 Bulletin 92/06**

(45) Publication of the grant of the patent :
**30.08.95 Bulletin 95/35**

(84) Designated Contracting States :
**DE GB**

(56) References cited :
EP-A- 0 061 388
EP-A- 0 161 556
GB-A- 2 097 185
GB-A- 2 179 790
US-A- 3 931 673
US-A- 4 500 742
26TH ELECTRONIC COMPONENTS CONFER-
ENCE, San Fransisco, 26th - 28th April 1976,
pages 344 - 349; Dr. L.W. BOS et al.: "A new
center tapped medium power microfilm resis-
tor"

(60) Publication number of the earlier application in
accordance with Art. 76 EPC : **0 289 618**

(73) Proprietor : **ANRITSU CORPORATION
10-27, Minamiazabu 5-chome
Minato-ku Tokyo 106 (JP)**

(72) Inventor : **Kodato, Setsuo
2551-1-205, Tsumada
Atsugi-shi, Kanagawa-ken 243 (JP)**
Inventor : **Nakamura, Masao
596-9, Imaizumi
Hatano-shi, Kanagawa-ken, 257 (JP)**

(74) Representative : **Patentanwälte Grünecker,
Kinkeldey, Stockmair & Partner
Maximilianstrasse 58
D-80538 München (DE)**

EP 0 469 638 B1

## Description

The invention relates to a power detector comprising a thin film conductor.

In Japanese Patent Disclosure No. 84-23263 one of the inventors of this invention has disclosed a thermocouple device made by connecting a mixed crystal film of the amorphous and microcrystal phases with a metal resistance film. A power detector using this thermocouple device is quite capable of stable measurement during high power detection. However, this power detector comprising the thermocouple is too low in sensitivity to perform stable measurement and has poor linearity in the thermoelectromotive force of the thermocouple in detecting low power, such as 1 $\mu$W for example. U.S. Patent Nos. 4,835,059 and 4,766,008, that one of the inventors of this invention have filed, discloses a Si-Ge alloy thin film conductor in which the amorphous and microcrystal phases coexist. This thin film conductor, though made of a semiconductor material, has a relatively large conductivity but the temperature coefficient is small like that of metals and also offers a feature that the thermoelectric power (the Seebeck coefficient magnitude) is large like that of semiconductors; therefore, the thermoelectromotive force is large. In the above patent application, the applicability to electric resistors and power detectors is indicated.

In view of this prior art, it is the object of the invention to provide a power detector having improved detection sensitivity and excellent linearity in the low power range.

This object is solved by a power detector having the features of Claim 1.

Preferred embodiments are disclosed in the dependent claims.

The invention uses an alloy thin film chiefly consisting of silicon and germanium, in which the amorphous and microcrystal phases coexist for a material constituting one of the thermocouples and utilizes the properties of the alloy thin film that the conductivity is high, the temperature coefficient of the conductivity is small, the thermoelectromotive force is large and the conductivity is substantially constant from direct current to frequencies up to 32 GHz.

The above-mentioned alloy thin film conductor is manufactured using microelectronics processes such as the plasma CVD process and the photo assisted CVD process as indicated in U.S. Patent No.4,766,008.

The Si-Ge alloy thin film conductor thus produced has a crystallinity (the proportion of microcrystals to the total) of 10% to 90%. The microcrystals consist of silicon and germanium. The average grain size is about 50 to 500 Å. The conductivity is at least 0.1 S·cm$^{-1}$. The ratio of conductivity change with the measuring frequency is less than 20% (less than 1 dB) from direct current to 32 GHz.

In the power detector, a thermocouple is made by connecting the above-mentioned alloy thin film with a conductor film. One or more thermocouples in combination are arranged on an insulating substrate. The alloy thin film in the above-mentioned thermocouple is connected with a first electrode. The conductor film of the thermocouple is connected with a second electrode. The first electrode is connected with a first beam lead electrode and the second electrode is connected with a second beam lead electrode.

The power detector of this invention, makes it possible:

To provide a power detector with improved linearity, particularly in the low power detection range, by furnishing beam lead electrodes thereby increasing the temperature difference between the hot and cold junctions of the thermocouple.

In conventional power detectors using a semiconductor film and a metal resistance film, the upper limit working frequency is 18 GHz, the detectable power range is 10 $\mu$W to 160 mW and the detection response speed is 0.7 sec. In contrast, with the power detector in this invention, because of the use of the above-mentioned alloy thin film and beam lead electrodes, the upper limit working frequency is increased to 32 GHz and the detectable power range is widened from 1 $\mu$W to 500 mW. In addition, since microminiaturized elements can be formed by using micro processing techniques such as photolithography, the detection response speed is reduced to less than 0.06 sec.

It is now possible to provide a less expensive power detector since the structure is simpler than that of the conventional power detector using semiconductor film and metal resistance film.

Figure 1A shows an example of the power detector of this invention;

Figure 1B shows another example of the power detector of this invention;

Figure 2 is a sectional view taken along line X-X of Figure 1A;

Figure 3 is a top view example of a power detecting apparatus. The power detector according to this invention is so applied;

Figure 4 is the electrical circuit diagram of the power detecting apparatus shown in Figure 3;

Figure 5 shows the power detecting apparatus shown in Figure 3 connected with a coaxial circuit;

Figure 6 is characteristic of the linearity of the detection sensitivity against the incident power obtained by the power detector of this invention;

Figure 7 shows the frequency characteristics of the detection sensitivity at an incident power of 1 mV obtained by the power detector of this invention; and

Figure 8 shows the frequency characteristics of the power reflection coefficient obtained by the power detector of this invention.

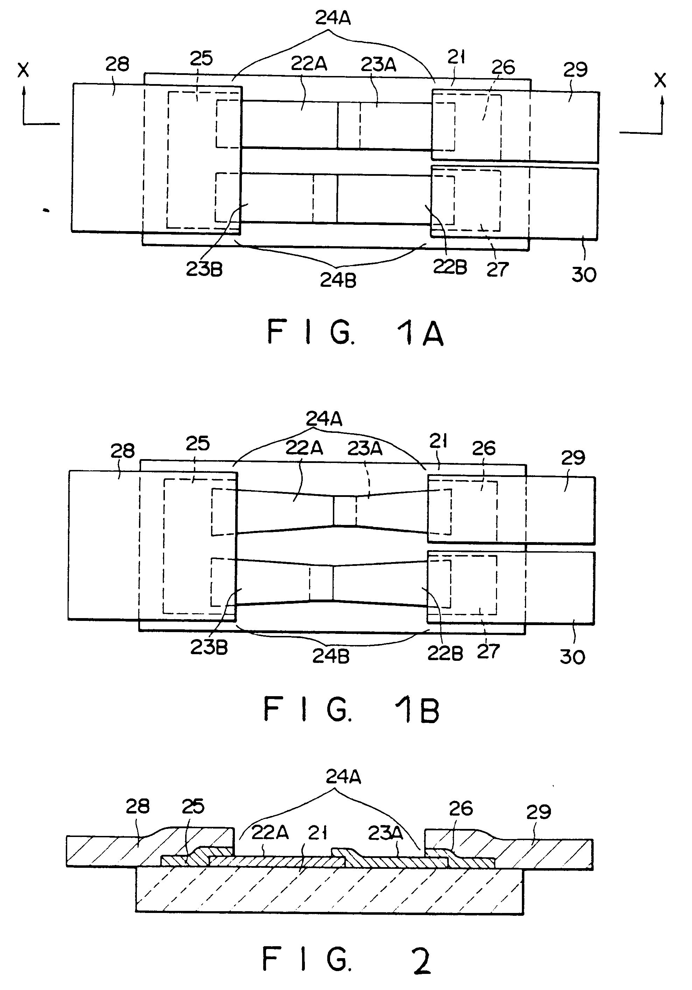

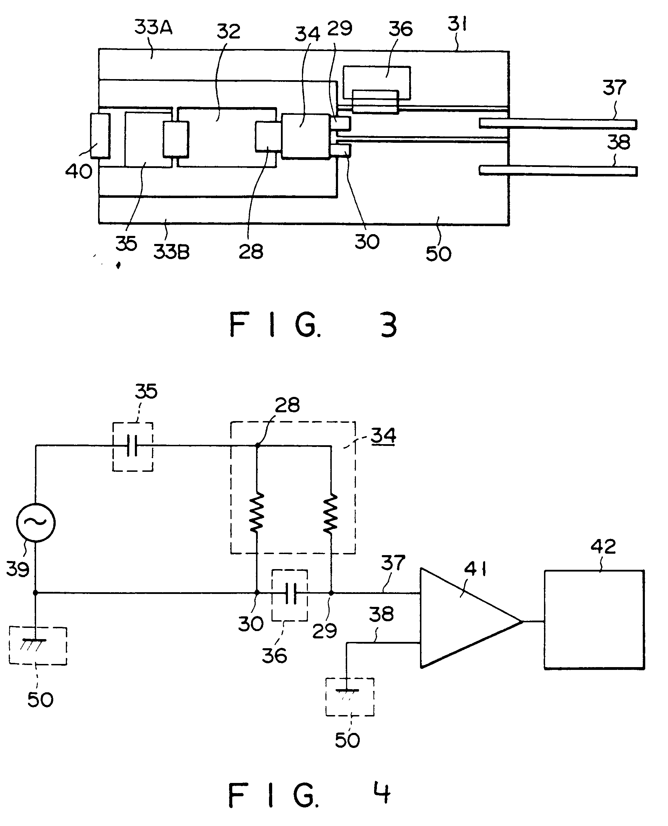

An embodied example of a power detector utilizing an Si-Ge alloy thin film conductor, in which the amorphous phase and the microcrystal phase coexist, will now be described. In Figures 1A and 2, in the power detector, first thermocouple 24A is comprised of an Si-Ge alloy thin film conductor 22A and the metal conductor film 23A connected thereto; the second thermocouple 24B is comprised of the Si-Ge alloy thin film conductor 22B and the metal conductor film 23B connected thereto. First thermocouple 24A and second thermocouple 24B are provided in parallel on insulating substrate 21 such that the Si-Ge alloy thin film of the first thermocouple and the metal film of the second thermocouple are placed facing each other, and the Si-Ge alloy thin film of the second thermocouple and the metal film of the first thermocouple are placed facing each other. The Si-Ge alloy thin film of the first thermocouple and the metal film of the second thermocouple are bridged by first electrode 25; the metal film of the first thermocouple is connected with second electrode 26; the Si-Ge alloy thin film of the second thermocouple is connected with third electrode 27 and thereby the outputs of the two thermocouples can be put together. First, second and third electrodes 25, 26 and 27 are connected tightly with beam lead electrodes 28, 29 and 30 respectively. The desired widths of these beam lead electrodes are wider than those of the electrodes to which the beam lead electrodes are connected and are 100 to 200 μm. The desired thicknesses of the beam lead electrodes are 5 to 30 μm, and more desirably 10 to 20 μm. Gold or gold-plated platinum are the materials normally used for the beam lead electrodes. By attaching beam lead electrodes to the outer ends, that is, the cold junctions of the thermocouples as in this embodiment, the thermal resistance of the cold junction areas can be reduced considerably. In addition, by bonding the beam lead electrodes to a strip substrate, the temperature difference from the ambient temperature, that is, the thermal gradient, can be minimized.

Meanwhile, the thermal resistance between the junctions of the thermocouples, that is, between the hot junction and the cold junctions, is determined by the thicknesses and the widths of the insulating substrate, the Si-Ge alloy thin film conductor and the metal film. This thermal resistance is far greater than that of the cold junctions. In other words, the thermal gradient between the hot and cold junctions of the thermocouple can be increased. Therefore, by increasing the distance between the hot and cold junctions, the thermal resistance between them can be increased. As a result, the temperature difference T between them is increased.

The afore-mentioned power detector is constructed so that the outputs of the two thermocouples can be added. The thermoelectromotive force V can be expressed by the thermoelectric power $\alpha_a$ of the Si-Ge alloy thin film and the thermoelectric power $\alpha_m$ of the metal film as follows.

$$V = 2(\alpha_a + \alpha_m) T \quad (1)$$

As is clear from this equation, the thermoelectromotive force V, that is, the detection sensitivity, increases as the temperature difference T increases. Therefore, this power detector, in detecting very low power, can reduce the influence of noise and thereby improved linearity of this power detector.

In this embodiment, the Si-Ge alloy thin film and conductor film, constituting the thermocouples, are rectangular in shape, but this invention is not limited to rectangular thermocouples. To give an example, it is possible to make trapezoidal mixed crystal film and metal film such that the hot junction edges become narrower toward the cold junction edges as shown in Figure 1B. With such trapezoidal thermocouples, the temperature between the hot and cold junctions can be changed by concentrating heat generation in the hot junction areas thereby improving detection sensitivity. Though two thermocouples were used in this power detector embodiment, the number of thermocouples may be one, three or more. A metal was used for the conductor films in this embodiment, but other types of conducting material can be used. When the Si-Ge alloy thin film is a p-type semiconductor, for example, the detection sensitivity can be improved by using an n-type semiconductor, which differs in pole of thermoelectric power, as a substitute for the conductor film.

Figures 3 and 4 show a power detection device using the power detector shown in Figure 1A. In this device, a transmission line is made, on dielectric substrate 31, by central conductor 32 having a specified width and outer conductors 33A and 33B disposed on both sides of the device and separated by specified distances from the central conductor 32. The power detector 34 has beam lead electrodes 28, 29 and 30 connected to the transmission lines, respectively, and the power being measured is suppled to the detector through the lines. Coupling capacitor 35, connected in series in the circuit, cuts off direct current but allows high frequency power to pass. Bypass capacitor 36 performs the same function as coupling capacitor 35. In this power detection device, thermoelectromotive force 37 is generated as power being measured and converted into heat. This detection output appears as direct current at beam lead electrodes 28, 29 and 30 and is taken out by lead wires 37 and 38. Numeral 40 indicates a connecting part. The d.c. output voltage is amplified by amplifier 41 and indicated at indicator 42. Numeral 50 indicates the earth connection.

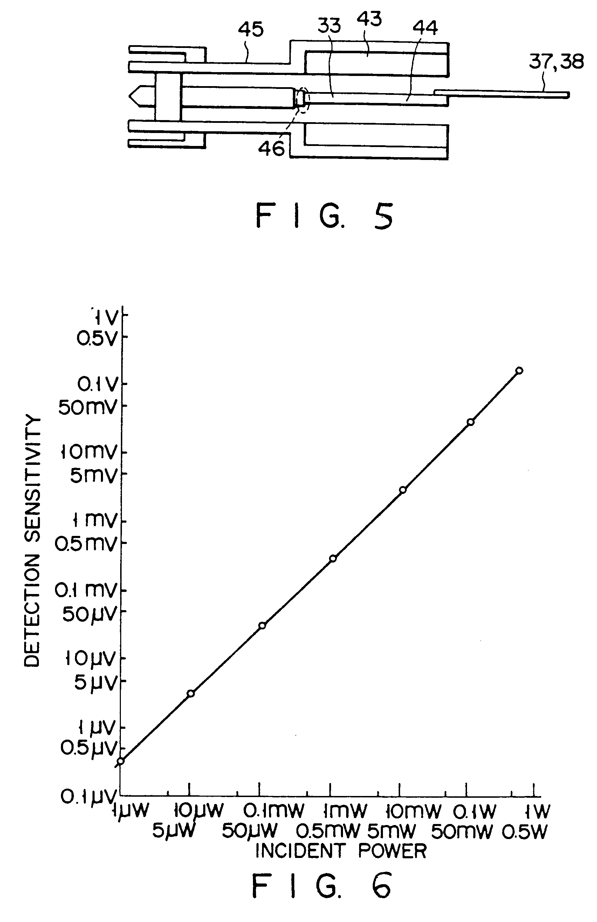

Figure 5 is a sectional view showing the power detection device shown in Figure 3 being connected with a coaxial transmission line. In Figure 5, numeral 43 indicates a hollow outer connector, into which power detection device 44 is inserted and the central conductor of coaxial transmission line 45 is connected at connecting part 46 with central conductor 33 of power detection device 44.

Figure 6 shows the linearity of the detection sensitivity in relation to the supplied power into the power detector. The axis of abscissa represents the supplied power and the axis of ordinates the detection sensitivity both in logarithmic scale.

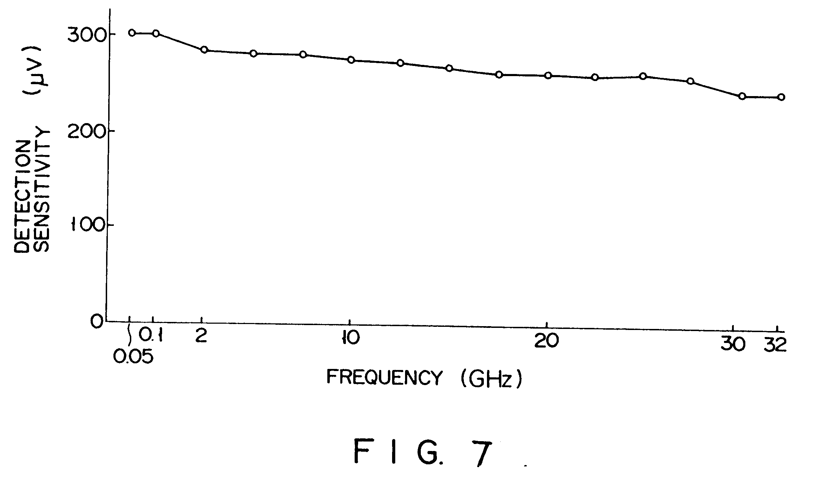

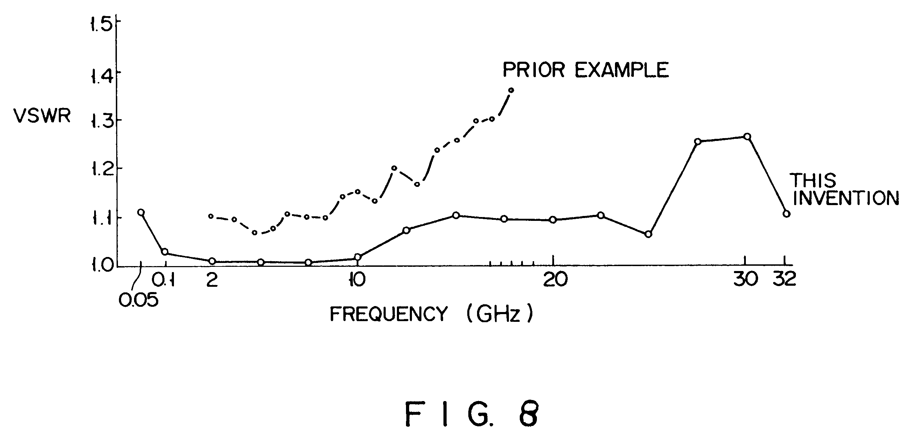

As can be seen from this diagram, the power detection device of this invention offers excellent linearity from low power to high power. One of the reasons why data with such a good linearity was obtained with high sensitivity in detecting low power is that the thermal resistance of the thermocouples was made large by using an Si-Ge alloy thin film with a thickness of about 1 μm. Figure 7 shows the frequency characteristics of the detection sensitivity in the power detection device of this invention. The frequency characteristics are flat; less than 1 dB up to 32 GHz. Figure 8 shows the frequency characteristics of the VSWR (voltage standing wave ratio) in the power detector of this invention. Fine impedance matching is achieved such that the VSWR is less than 1.3 up to 32 GHz and the characteristics of the power detector of this invention are more excellent than those of the prior example indicated by the broken line in Figure 8.

## Claims

1. A power detector having a thin film conductor comprising:

   an insulating substrate (21);

   at least one thermocouple (24A,24B) provided on said insulating substrate (21), each being formed by connecting a conductor film (23A) to an alloy film (22A), said alloy film (22A) essentially consisting of silicon and germanium, in which the amorphous and microcrystal phases coexist;

   a first electrode (25) connected to said alloy film (22A);

   a second electrode (26) connected to said conductor (23A);

   a first beam lead electrode (28) connected to said first electrodes (25); and

   a second beam lead electrode (29) connected to said second electrode (26).

2. The power detector of Claim 1 **characterized in that** two thermocouples (24A,24B) are provided in parallel on said insulating substrate (21) such that the alloy film (22A) of the first thermocouple (24A) and the conductor film (23B) of the second thermocouple (24B) are located on the same edge, and the alloy film (22B) of the second thermocouple (24B) and the conductor film (23A) of the first thermocouple (24A) are located on the other edge; each of said alloy film (22A) of the first thermocouple (24A) and the conductor film (23B) of the second thermocouple (24B) having a first electrode (25) connected thereon; said conductor film (23A) of the first thermocouple (24A) having a second electrode (26) connected thereon; said conductor film (23A) with the second electrode (26) connected thereon has a third electrode (27) which is connected thereto, said first, second and third electrodes (25,26,27) being respectively connected with first, second and third lead electrodes (28,29,30).

3. The power detector of Claim 1 or 2 **characterized in that** said beam lead electrodes (28,29,30) are wider than the widths of the electrodes (25,26,27) to which the beam lead electrodes (28,29,30) are connected.

4. The power detector of Claim 3 **characterized in that** said beam lead electrodes (28,29,30) are each 5 to 30 μm thick and 100 to 200 μm wide.

5. The power detector of any of the Claims 1 to 4 **characterized in that** the alloy films (22A,22B) and the conductor films (23A,23B) both constituting the thermocouples (24A,24B) are each in a trapezoidal shape, the hot junction area where the alloy film (22A,22B) and the conductor film (23A,23B) are connected with each other being narrow, the cold junction areas at both ends of said thermocouples (24A,24B) being wide.

6. The power detector of any of the Claims 1 to 5 **characterized in that** the alloy film (22A,22B) has the dark-conductivity $\alpha_D$ of not smaller than 1 S·cm$^{-1}$, the temperature coefficient $\alpha$ of the dark conductivity of not larger than 1%/K and the thermoelectric power S of not smaller than 10 μV/K.

7. The power detector of any of the Claims 1 to 6 **characterized in that** the frequency characteristics of the detection sensitivity changes within a range of 1 dB up to 32 GHz.

8. The power detector of any of the Claims 1 to 7 **characterized in that** the VSWR (voltage standing wave ratio) is in a range from 1.0 to 1.3 up to 32 GHz.

9. The power detector of any of the Claims 1 to 8 **characterized in that**

the detection response speed is less than 0.06 sec.

**Patentansprüche**

1. Eine Leistungserfassungseinrichtung mit einem Dünnschichtleiter, umfassend:
   ein isolierendes Substrat (21);
   wenigstens ein Thermoelement (24A, 24B), das auf dem genannten isolierenden Substrat (21) vorgesehen ist, wobei jedes durch Verbinden einer Leiterschicht (23A) mit einer Legierungsschicht (22A) gebildet wird, wobei die genannte Legierungsschicht (22A) im wesentlichen aus Silicium und Germanium besteht, in der die amorphe und mikrokristalline Phase gemeinsam vorhanden sind;
   eine erste Elektrode (25), die mit der genannten Legierungsschicht (22A) verbunden ist;
   eine zweite Elektrode (26), die mit dem genannten Leiter (23A) verbunden ist;
   eine erste Flachleiteranschlußelektrode (28), die mit der genannten ersten Elektrode (25) verbunden ist; und eine zweite Flachleiteranschlußelektrode (29), die mit der genannten zweiten Elektrode (26) verbunden ist.

2. Die Leistungserfassungseinrichtung des Anspruches 1, **dadurch gekennzeichnet, daß** zwei Thermoelemente (24A, 24B) parallel zueinander auf dem genannten isolierenden Substrat (21) so vorgesehen sind, daß die Legierungsschicht (22A) des ersten Thermoelements (24A) und die Leiterschicht (23B) des zweiten Thermoelements (24B) an dem gleichen Rand angeordnet sind, und die Legierungsschicht (22B) des zweiten Thermoelements (24B) und die Leiterschicht (23A) des ersten Thermoelements (24A) an dem anderen Rand angeordnet sind; jede der genannten Legierungsschicht (22A) des ersten Thermoelements (24A) und der Leiterschicht (23B) des zweiten Thermoelements (24B) eine damit verbundene erste Elektrode (25) aufweist; die genannte Leiterschicht (23A) des ersten Thermoelements (24A) eine zweite Elektrode (26) mit ihr verbunden aufweist; die genannte Leiterschicht (23A) mit der mit ihr verbundenen zweiten Elektrode (26) eine dritte Elektrode (27) damit verbunden aufweist, wobei die genannte erste, zweite und dritte Elektrode (25, 26, 27) jeweils mit der ersten, zweiten und dritten Anschlußelektrode (28, 29, 30) verbunden ist.

3. Die Leistungserfassungseinrichtung des Anspruches 1 oder 2, **dadurch gekennzeichnet, daß** die genannten Flachleiteranschlußelektroden (28, 29, 30) weiter als die Weiten der Elektroden (25, 26, 27) sind, mit denen die Flachleiteranschlußelektroden (28, 29, 30) verbunden sind.

4. Die Leistungserfassungseinrichtung des Anspruches 3, **dadurch gekennzeichnet, daß** die genannten Flachleiteranschlußelektroden (28, 29, 30) jeweils 5 bis 30 $\mu$m dick und 100 bis 200 $\mu$m weit sind.

5. Die Leistungserfassungseinrichtung nach irgendeinem der Ansprüche 1 bis 4, **dadurch gekennzeichnet, daß** die Legierungsschichten (22A, 22B) und die Leiterschichten (23A, 23B), die beide die Thermoelemente (24A, 24B) bilden, jeweils eine trapezförmige Form haben, der warme Verbindungsstellenbereich, wo die Legierungsschicht (22A, 22B) und die Leiterschicht (23A, 23B) miteinander verbunden sind, schmal ist, die kalten Verbindungsstellenbereiche an beiden Enden der genannten Thermoelemente (24A, 24B) weit sind.

6. Die Leistungserfassungseinrichtung nach irgendeinem der Ansprüche 1 bis 5, **dadurch gekennzeichnet, daß** bei der Legierungsschicht (22A, 22B) die Dunkelleitfähigkeit $\alpha_D$ nicht weniger als 1 S·cm$^{-1}$, der Temperaturkoeffizient $\alpha$ der Dunkelleitfähigkeit nicht größer als 1%/K und die thermoelektrische Leistung S nicht kleiner als 10 $\mu$V/K ist.

7. Die Leistungserfassungseinrichtung nach irgendeinem der Ansprüche 1 bis 6, **dadurch gekennzeichnet, daß** sich die Frequenzeigenschaften der Erfassungsempfindlichkeit innerhalb eines Bereiches von 1 dB bis zu 32 GHz ändert.

8. Die Leistungserfassungseinrichtung nach irgendeinem der Ansprüche 1 bis 7, **dadurch gekennzeichnet, daß** die VSWR (Spannungs-Stehwellenverhältnis) in einem Bereich von 1,0 bis 1,3 bis zu 32 GHZ ist.

9. Die Leistungserfassungseinrichtung nach irgendeinem der Ansprüche 1 bis 8, **dadurch gekennzeichnet, daß** die Erfassungsreaktionsgeschwindigkeit niederer als 0,06 sec ist.

**Revendications**

1. Détecteur de puissance possédant un conducteur sous forme de pellicule mince, qui comprend :
   un substrat isolant (21) ;
   un ou plusieurs thermocouples (24A, 24B) placés sur ledit substrat isolant (21), chacun étant formé par connexion d'une pellicule de conducteur (23A) à une pellicule d'alliage (22A), ladite pellicule d'alliage (22A) étant constituée essentiellement de silicium et de germanium, dans lesquels les phases amorphe et microcristalline coexistent ;

une première électrode (25) connectée à ladite pellicule d'alliage (22A) ;

une deuxième électrode (26) connectée audit conducteur (23A) ;

une première électrode du type patte de puce, ou conducteur poutre, (28) connectée à ladite première électrode (25) ; et

une deuxième électrode du type conducteur poutre (29) connectée à ladite deuxième électrode (26).

2. Détecteur de puissance selon la revendication 1, caractérisé en ce que deux thermocouples (24A, 24B) sont disposés en parallèle sur ledit substrat isolant (21) de façon que la pellicule d'alliage (22A) du première thermocouple (24A) et la pellicule de conducteur (23B) du deuxième thermocouple (24B) soient placées du même côté, et que la pellicule d'alliage (22B) du deuxième thermocouple (24B) et la pellicule de conducteur (23A) du premier thermocouple (24A) soient placées de l'autre côté; chacune des pellicules que constituent ladite pellicule d'alliage (22A) du premier thermocouple (24A) et la pellicule de conducteur (23B) du deuxième thermocouple (24B) possédant une première électrode (25) connectée sur celles-ci; ladite pellicule de conducteur (23A) du premier thermocouple (24A) possédant une deuxième électrode (26) qui est connectée sur celle-ci; ladite pellicule de conducteur (23A) sur laquelle la deuxième électrode (26) est connectée possède une troisième électrode (27) qui lui est connectée, lesdites première, deuxième et troisième électrodes (25, 26, 27) étant respectivement connectées à des première, deuxième et troisième électrodes du type conducteur (28, 29, 30).

3. Détecteur de puissance selon la revendication 1 ou 2, caractérisé en ce que lesdites électrodes du type conducteur poudre (28, 29, 30) ont des largeurs plus grandes que celles des électrodes (25, 26, 27) auxquelles les électrodes du type conducteur poutre (28, 29, 30) sont connectées.

4. Détecteur de puissance selon la revendication 3, caractérisé en ce que lesdites électrodes du type conducteur poutre (28, 29, 30) ont chacune une épaisseur de 5 à 30 μm et une largeur de 100 à 200 μm.

5. Détecteur de puissance selon l'une quelconque des revendications 1 à 4, caractérisé en ce que les pellicules d'alliage (22A, 22B) et les pellicules de conducteur (23A, 23B) constituant deux à deux les thermocouples (24A, 24B) ont chacune une forme trapézoïdale, la zone de soudure chaude, ou de jonction de mesure, où la pellicule d'alliage (22A, 22B) et la pellicule de conducteur (23A, 23B) sont connectées l'une à l'autre étant étroite, les zones de soudure froide, ou de jonction de référence, qui se trouvent à l'une et l'autre extrémité desdits thermocouples (24A, 24B) étant larges.

6. Détecteur de puissance selon l'une quelconque des revendications 1 à 5, caractérisé en ce que la pellicule d'alliage (22A, 22B) possède une conductivité d'obscurité $\alpha_D$ qui n'est pas inférieure à 1 S.cm$^{-1}$, un coefficient de température $\alpha$ pour la conductivité d'obscurité qui n'est pas supérieur à 1 %/K et un pouvoir thermoélectriques qui n'est pas inférieur à 10 μV/K.

7. Détecteur de puissance selon l'une quelconque des revendications 1 à 6, caractérisé en ce que les caractéristiques de fréquence de la sensibilité de détection varient dans les limites d'un intervalle de 1 dB jusqu'à 32 GHz.

8. Détecteur de puissance selon l'une quelconque des revendications 1 à 7, caractérisé en ce que le taux d'ondes stationnaires en tension (VSWR) est compris dans l'intervalle de 1,0 à 1, 3 jusqu'à 32 GHz.

9. Détecteur de puissance selon l'une quelconque des revendications 1 à 8, caractérisé en ce que la vitesse de réponse de détection est inférieure à 0,06 s.

F I G. 1A

F I G. 1B

F I G. 2

F I G. 3

F I G. 4

F I G. 5

F I G. 6

9

F I G. 7

F I G. 8